# EUROPÄISCHE PATENTSCHRIFT

(11) **EP 3 520 585 B1**
(45) Veröffentlichungstag und Bekanntmachung des Hinweises auf die Patenterteilung: **30.12.2020**
(21) Anmeldenummer: 17764363.2
(22) Anmeldetag: 01.09.2017
(51) Int. Cl.: H05K 5/00, H05K 3/28

(54) **VERFAHREN ZUM HERSTELLEN EINER ELEKTRONISCHEN BAUGRUPPE UND ELEKTRONISCHE BAUGRUPPE, INSBESONDERE FÜR EIN GETRIEBESTEUERMODUL**
METHOD FOR PRODUCING AN ELECTRONIC ASSEMBLY, AND ELECTRONIC ASSEMBLY, IN PARTICULAR FOR A TRANSMISSION CONTROL MODULE
PROCÉDÉ DE FABRICATION D'UN COMPOSANT ÉLECTRONIQUE ET COMPOSANT ÉLECTRONIQUE, EN PARTICULIER POUR UN MODULE DE COMMANDE DE BOÎTE DE VITESSES

(30) Priorität: 30.09.2016 DE 102016219116
(43) Veröffentlichungstag der Anmeldung: 07.08.2019
(73) Patentinhaber: Robert Bosch GmbH, 70442 Stuttgart (DE)
(72) Erfinder: ZWEIGLE, Peter, 71254 Ditzingen (DE); DERINGER, Helmut, 74391 Erligheim (DE); HOFFMANN, Jens, 70376 Stuttgart (DE)
(86) Internationale Anmeldenummer: PCT/EP2017/072020
(87) Internationale Veröffentlichungsnummer: WO 2018/059873

(56) Entgegenhaltungen:
- EP-A2- 2 273 859
- DE-A1- 4 405 710
- DE-A1-102014 217 351
- US-A- 6 143 588

## Beschreibung

### Gebiet der Erfindung

Die Erfindung betrifft ein Verfahren zum Herstellen einer elektronischen Baugruppe, insbesondere für ein Getriebesteuermodul.

### Stand der Technik

Eine Vielzahl von elektronischen Baugruppen ist bekannt. Die elektronische Baugruppe muss, z.B. wenn sie Teile eines Getriebesteuermoduls ist, ölfest abgedichtet sein, da das Getriebesteuermodul in einer Ölumgebung ist. Die elektronische Baugruppe umfasst üblicherweise eine Leiterplatte mit darauf angeordneten elektronischen Bauelementen.

Große Einzelbauteile, wie z.B. Sensoren, werden teilweise nicht auf der Leiterplatte angeordnet und werden elektrisch mit der Leiterplatte verbunden. Da das Öl oftmals leitfähige Partikel enthält, ist eine elektrische Isolierung der Bauelemente sowie der elektrischen Verbindung zwischen dem großen Einzelbauteil, das nicht (vollständig) auf der Leiterplatte angeordnet ist, und der Leiterplatte notwendig. Hierzu kommen in der Regel Deckel bzw. Spanschutzdeckel zum Einsatz, welche aufgeclipst, genietet oder durch anderer Verfahren auf der Leiterplatte niedergehalten werden, um eine öldichte und/oder spandichte Abdichtung herzustellen.

Nachteilig hieran ist, dass das Getriebesteuermodul mit der elektronischen Baugruppe bzw. die elektronische Baugruppe wenig stabil bzw. robust ist und hohe Herstellungskosten sowie einen hohen Herstellungsaufwand aufweist.

Zudem können im Allgemeinen mechanische Spannungen zwischen dem großen Einzelbauteil und der Leiterplatte auftreten, wodurch die Lebensdauer bzw. Dichtheit des Getriebesteuermoduls bzw. der elektronische Baugruppe sinkt. Des Weiteren kann in der Regel aufgrund der Dickentoleranz der Leiterplatte die elektronische Baugruppe nur sehr ungenau in der Höhenlage platziert werden, was insbesondere bei Sensoren zu Problemen führen kann.

Aus der US 6 143 588 und aus der DE 44 05 710 A1 sind Verfahren zum Herstellen elektronischer Baugruppen bekannt, bei denen eine mit einem ersten Bauelement versehen Leiterplatte auf einer Referenzoberfläche angeordnet wird und ein nicht-fließfähiges Abdichtungsmaterial auf die Leiterplatte aufgebracht wird, das beim Auftragen über einem zweiten Bauelement und elektrischen Verbindungsmitteln des zweiten Bauelementes mit der Leiterplatte aufgebracht wird.

### Offenbarung der Erfindung

### Vorteile der Erfindung

Die vorliegende Erfindung stellt ein Verfahren zum Herstellen einer elektronische Baugruppe, insbesondere für ein Getriebesteuermodul, bereit, die öldicht ist und eine hohe Robustheit, geringe Herstellungskosten und eine hohe Lebensdauer aufweist. Dadurch, dass im Wesentlichen keine mechanischen Spannungen zwischen dem Bauteil, das nicht vollständig auf der Leiterplatte angeordnet ist, und der Leiterplatte auftreten, ist eine dauerhafte Öldichtheit gegeben. Durch das Einsparen eines Spanschutzdeckels vereinfacht sich der Herstellungsprozess. Des Weiteren ist es in der Regel möglich, die elektronische Baugruppe auf dieselbe Referenzfläche wie die Elektronik selbst zu platzieren

Gemäß der Erfindung wird ein Verfahren zum Herstellen einer elektronischen Baugruppe, insbesondere für ein Getriebesteuermodul, vorgeschlagen, folgende Schritte umfassend: Bereitstellen einer Leiterplatte mit einer ersten Seite und einer von der ersten Seite abgewandten zweite Seite und mit wenigstens einem ersten auf der ersten Seite der Leiterplatte angeordneten elektronischen Bauelement; Anordnen der Leiterplatte mit der zweiten Seite zumindest teilweise auf einer Referenzoberfläche; Aufbringen eines vor einem Aushärten nicht-fließfähigen Abdichtungsmaterials mit hoher Viskosität auf die erste Seite, wobei das Abdichtungsmaterial nach dem Aufbringen nicht fließt, so dass sich die von dem Abdichtungsmaterial bedeckte Fläche nach dem Aufbringen auf die erste Seite der Leiterplatte und vor dem Eindrücken eines zweiten Bauelementes nicht ändert, und wobei das Abdichtungsmaterial derart aufgebracht wird, dass das Abdichtungsmaterial einen Teilbereich der ersten Seite der Leiterplatte umgibt; Anordnen eines zweiten Bauelements zumindest teilweise auf der Referenzoberfläche derart, dass das zweite Bauelement teilweise in das Abdichtungsmaterial eingedrückt wird; wobei der Schritt des Anordnens des zweiten Bauelementes nach dem Schritt der Aufbringung des nicht-fließfähigen Abdichtungsmaterials erfolgt; Elektrisches Verbinden des zweiten Bauelements mit der Leiterplatte mittels einer elektrischen Verbindungsleitung; Aufbringen eines Bedeckungsmaterials, insbesondere eines vor einem Aushärten fließfähigen Bedeckungsmaterials, auf den von dem Abdichtungsmaterial umgebenen Teilbereich der ersten Seite der Leiterplatte und auf das erste Bauelement; Aushärten des Abdichtungsmaterials; und Aushärten des Bedeckungsmaterials.

Ideen zu Ausführungsformen der vorliegenden Erfindung können unter anderem als auf den nachfolgend beschriebenen Gedanken und Erkenntnissen beruhend angesehen werden.

In einer Ausführungsform ist die Referenzoberfläche die Oberfläche einer Wärmesenke zum Ableiten von Wärme aus der elektronischen Baugruppe. Ein Vorteil hiervon ist, dass die Leiterplatte in gutem thermischen Kontakt mit der Referenzoberfläche bleibt. Hierdurch kann die Wärme aus der elektronischen Baugruppe, insbesondere von dem ersten Bauelement gut abgeleitet werden.

In einer Ausführungsform ist die Referenzoberfläche die Oberfläche eines Montagehilfsmittels ist, und wobei das Verfahren ferner folgenden Schritt umfasst: Entfernen der Leiterplatte und des zweiten Bauelements von dem Montagehilfsmittel. Hierdurch können in der Regel die Leiterplatte und das zweite Bauelement technisch einfach zu einer Montagefläche bzw. der Oberfläche des Montagehilfsmittels gleich ausgerichtet werden. Durch das Entfernen des Montagehilfsmittels nach dem Ausrichten wird die Flexibilität der Installation bzw. des Installationsorts der Leiterplatte und des zweiten Bauelements erhöht. Das Montagehilfsmittel kann üblicherweise jede Art von Vorrichtung sein, die eine ebene bzw. plane Oberfläche aufweist. Das Montagehilfsmittel kann z.B. ein Ausrichttisch oder ein Montagetisch sein.

In einer Ausführungsform wird das Abdichtungsmaterial auf einen Randbereich der ersten Seite der Leiterplatte aufgebracht. Hierdurch wird sichergestellt, dass im Wesentlichen die gesamte erste Seite der Leiterplatte von dem Bedeckungsmaterial abgedeckt wird. Dies stellt die elektrische Isolation der Leiterplatte von der Umgebung sicher.

In einer Ausführungsform wird das Bedeckungsmaterial derart auf die erste Seite der Leiterplatte aufgebracht, dass das Bedeckungsmaterial die elektrische Verbindungsleitung bedeckt und/oder umschließt. Hierdurch wird sichergestellt, dass die elektrische Verbindungsleitung technisch einfach ebenfalls von der Umgebung elektrisch isoliert ist.

In einer Ausführungsform des Verfahrens weist das Abdichtungsmaterial und das Bedeckungsmaterial den gleichen Wärmeausdehnungskoeffizienten auf. Hierdurch wird das Auftreten mechanischer Spannung noch sicherer vermieden. Es wird darauf hingewiesen, dass einige der möglichen Merkmale und Vorteile der Erfindung hierin mit Bezug auf unterschiedliche Ausführungsformen der elektronischen Baugruppe beschrieben sind. Ein Fachmann erkennt, dass die Merkmale in geeigneter Weise kombiniert, angepasst oder ausgetauscht werden können, um zu weiteren Ausführungsformen der Erfindung zu gelangen.

### Kurze Beschreibung der Zeichnungen

Nachfolgend werden Ausführungsformen der Erfindung unter Bezugnahme auf die beigefügten Zeichnungen beschrieben, wobei weder die Zeichnungen noch die Beschreibung als die Erfindung einschränkend auszulegen sind.
- Fig. 1 zeigt: eine schematische Ansicht nach einem ersten Schritt des erfindungsgemäßen Verfahrens zum Herstellen einer elektronischen Baugruppe;
- Fig. 2 zeigt: eine schematische Ansicht nach einem zweiten Schritt des erfindungsgemäßen Verfahrens zum Herstellen einer elektronischen Baugruppe;
- Fig. 3 zeigt: eine schematische Ansicht nach einem dritten Schritt des erfindungsgemäßen Verfahrens zum Herstellen einer elektronischen Baugruppe;
- Fig. 4 zeigt: eine schematische Ansicht einer Ausführungsform der erfindungsgemäßen elektronischen Baugruppe; und
- Fig. 5 zeigt: eine Querschnittsansicht der elektronischen Baugruppe aus Fig. 4 entlang der Linie V-V.

Die Figuren sind lediglich schematisch und nicht maßstabsgetreu. Gleiche Bezugszeichen bezeichnen in den Figuren gleiche oder gleichwirkende Merkmale.

### Ausführungsformen der Erfindung

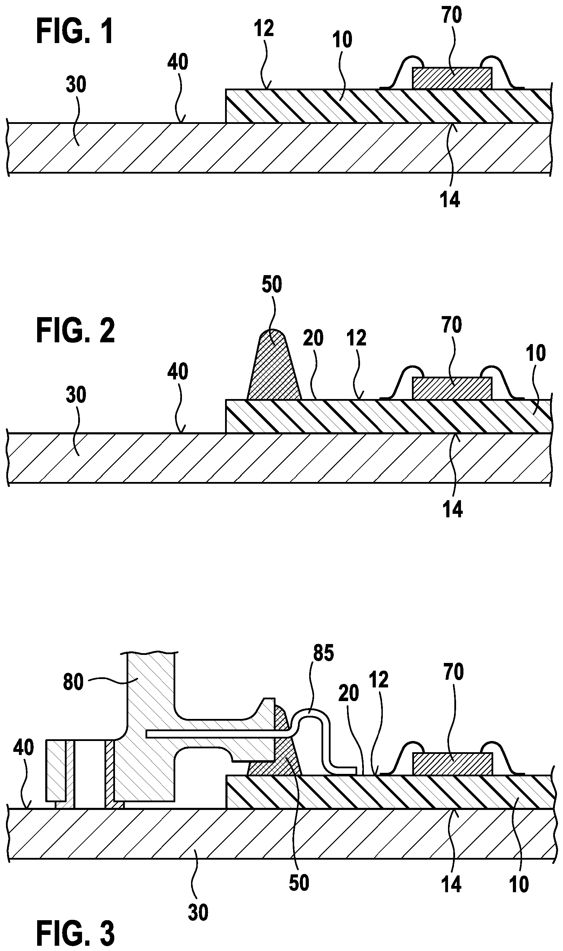

Fig. 1 zeigt eine schematische Ansicht nach einem ersten Schritt des erfindungsgemäßen Verfahrens zum Herstellen einer elektronischen Baugruppe 5. Die elektronische Baugruppe 5 kann Teil eines Getriebesteuermoduls für ein Fahrzeug sein.

Zunächst wird eine Leiterplatte 10 (z.B. ein printed circuit board; PCB) bereitgestellt. Die Leiterplatte 10 weist eine erste Seite 12 (in Fig. 1 oben) und eine zweite Seite 14 (in Fig. 1 unten) auf, wobei die zweite Seite 14 der ersten Seite 12 gegenüberliegt. Auf der ersten Seite 12 der Leiterplatte 10 ist mindestens ein erstes elektronisches Bauelement 70 angeordnet. Das erste elektronische Bauelement 70 ist mit der Leiterplatte 10 elektrisch verbunden.

Die Leiterplatte 10 ist auf einer Referenzoberfläche 40 angeordnet. Die zweite Seite 14 der Leiterplatte 10 ist mit der Referenzoberfläche 40 flächig verbunden bzw. auf dieser befestigt. Alternativ kann die Leiterplatte auch nur während der Herstellung auf einer Referenzfläche bzw. Montagefläche bzw. Oberfläche eines Montagehilfsmittels aufliegen. Die Referenzoberfläche 40 kann die Oberfläche eines Gehäuses des Getriebesteuermoduls sein oder lediglich bei der Herstellung vorhanden sein. Die Referenzoberfläche 40 ist insbesondere die Oberfläche einer Wärmesenke 30, die Wärme aus der elektronische Baugruppe 5 bzw. den ersten Bauelementen 70/der Leiterplatte 10 abführt. Die Wärmesenke 30 kann z.B. das Gehäuse eines Getriebesteuermoduls sein, dessen Teil die elektronische Baugruppe 5 ist.

Die Leiterplatte 10 kann auf die Referenzoberfläche 40 aufgeklebt sein. Andere Arten der Befestigung sind vorstellbar.

Fig. 2 zeigt eine schematische Ansicht nach einem zweiten Schritt des erfindungsgemäßen Verfahrens zum Herstellen einer elektronischen Baugruppe 5. Nach dem Bereitstellen der auf der Referenzoberfläche 40 angeordneten Leiterplatte 10 mit mindestens einem ersten elektronischen Bauelement 70 wird nun ein Abdichtungsmaterial 50 auf die erste Seite 12 der Leiterplatte 10 aufgebracht.

Das Abdichtungsmaterial 50 wird derart auf die erste Seite 12 der Leiterplatte 10 aufgebracht, dass das Abdichtungsmaterial 50 einen Bereich bzw. Teilbereich 20 der ersten Seite 12 der Leiterplatte 10 umgibt. Die ersten Bauelemente 70 auf der ersten Seite 12 der Leiterplatte 10 sind in dem von dem Abdichtungsmaterial 50 umgebenen Teilbereich 20 der ersten Seite 12 der Leiterplatte 10 angeordnet.

Das Abdichtungsmaterial 50 dient zum Bilden einer Begrenzung auf der ersten Seite 12 der Leiterplatte 10, die eine Begrenzung des fließfähigen Bedeckungsmaterials 60 bildet, so dass bei der späteren Einbringung des Bedeckungsmaterials 60 gezielt nur der Teilbereich 20 der ersten Seite 12 der Leiterplatte 10 von dem Bedeckungsmaterial 60 bedeckt wird und das Bedeckungsmaterial 60 nicht in Bereiche fließt, die nicht von dem Bedeckungsmaterial 60 bedeckt werden sollen.

Das Abdichtungsmaterial 50 kann am Rand der ersten Seite 12 der Leiterplatte 10 auf die erste Seite 12 der Leiterplatte 10 bzw. einen Teil hiervon aufgebracht werden. Vorstellbar ist auch, dass das Abdichtungsmaterial 50 beabstandet zum Rand der ersten Seite 12 der Leiterplatte 10 aufgebracht wird. Auch ist möglich, dass in bestimmten Bereichen das Abdichtungsmaterial 50 am Rand der ersten Seite 12 der Leiterplatte 10 aufgebracht wird und in anderen Bereichen das Abdichtungsmaterial 50 beabstandet zum Rand der ersten Seite 12 der Leiterplatte 10 aufgebracht wird.

Das Abdichtungsmaterial 50 ist ein sogenanntes Dam-Material. D.h., dass das Abdichtungsmaterial 50 eine hohe Viskosität aufweist. Insbesondere fließt das Abdichtungsmaterial 50 nach dem Aufbringen nicht und breitet sich nicht auf der ersten Seite 12 der Leiterplatte 10 aus. Die von dem Abdichtungsmaterial 50 bedeckte Fläche änderte sich nach dem Aufbringen des Abdichtungsmaterials 50 auf die erste Seite 12 der Leiterplatte 10 (zumindest vor dem Anordnen und Eindrücken des zweiten Bauelements 80) nicht.

Das Abdichtungsmaterial 50 kann z.B. ein Epoxidharz mit Füllstoffen sein.

Das Abdichtungsmaterial 50 wird in einer derartigen Höhe (die Höhe verläuft in Fig. 2 von unten nach oben) aufgebracht bzw. weist eine Höhe auf, die größer ist als die Höhe des ersten Bauelements 70 und des dazugehörigen wire-bond bzw. der dazugehörigen wire-bonds bzw. der dazugehörigen elektrischen Verbindungsleitung 85. Auch vorstellbar ist, das Bauelement 70 mittels Löten auf der Leiterplatte 10 befestigt ist. Somit ist sichergestellt, dass eine genügend hohe Begrenzung bzw. ein genügend hoher Rand auf der ersten Seite 12 der Leiterplatte 10 um das erste Bauelement 70 vorhanden ist, um das fließfähige Bedeckungsmaterial 60 in einem späteren Verfahrensschritt derart auf den Teilbereich der ersten Seite 12 der Leiterplatte 10, der von dem Abdichtungsmaterial 50 begrenzt bzw. umrahmt ist, aufzubringen, dass das erste Bauelement 70 (sowie seine elektrischen Verbindungen und evtl. weitere auf der ersten Seite 12 der Leiterplatte vorhandene elektrische Bauelemente) von dem Bedeckungsmaterial 60 vollständig bedeckt ist bzw. sind. Dadurch werden das erste Bauelement 70 und seine elektrischen Verbindungen (sowie weitere elektrische Bauelemente auf der ersten Seite 12 der Leiterplatte 10, insbesondere alle elektrischen Bauelemente auf der ersten Seite 12 der Leiterplatte 10) sicher (gegenüber der Ölumgebung) elektrisch isoliert.

Fig. 3 zeigt eine schematische Ansicht nach einem dritten Schritt des erfindungsgemäßen Verfahrens zum Herstellen einer elektronischen Baugruppe 5. Nun wird das zweite Bauelement 80 angeordnet. Das zweite Bauelement 80 kann ein Sensor und/oder ein Stecker sein. Das zweite Bauelement 80 wird derart angeordnet, dass das zweite Bauelement 80 teilweise auf der Referenzoberfläche 40 angeordnet ist.

Das zweite Bauelement 80 hat eine derartige Form und wird derart auf der Referenzoberfläche 40 angeordnet, dass das zweite Bauelement 80 in das Abdichtungsmaterial 50 eindrückt wird. Das zweite Bauelement 80 wird so tief in das Abdichtungsmaterial 50 eingedrückt, dass das zweite Bauelement 80 mit einem Teil plan auf der Referenzoberfläche 40 angeordnet ist.

Der Zwischenraum zwischen dem Teil des zweiten Bauelements 80, das sich (in Fig. 3) oberhalb der ersten Seite 12 der Leiterplatte 10 befindet und der ersten Seite 12 der Leiterplatte 10 wird hierdurch durch das Abdichtungsmaterial 50 öldicht bzw. flüssigkeitsdicht abgedichtet. Beim Eindrücken des zweiten Bauelements 80 in das Abdichtungsmaterial 50 ist das Abdichtungsmaterial 50 noch nicht ausgehärtet, sondern (zäh)flüssig.

Durch die beschriebene Anordnung und Ausbildung des zweiten Bauelements 80 entstehen keine mechanischen Spannungen in dem zweiten Bauelement 80 bzw. in der Leiterplatte 10.

Das zweite Bauelement 80 weist eine elektrische Verbindungsleitung 85, z.B. einen Wire-Bond, auf, mittel der das zweite Bauelement 80 elektrisch mit der ersten Seite 12 der Leiterplatte 10 verbunden wird. Die elektrische Verbindungsleitung 85 befindet sich oberhalb des Teilbereichs 20 der ersten Leiterplatte 10, der von dem Abdichtungsmaterial 50 umgeben bzw. umschlossen ist.

Das zweite Bauelement 80 wird in einem derartigen Abstand in horizontaler Richtung (in Fig. 3 verläuft die horizontale Richtung von links nach rechts) von der Leiterplatte 10 angeordnet, dass ein der Leiterplatte 10 zugewandtes Ende in das Abdichtungsmaterial 50 drückt. Die elektrische Verbindungsleitung 85 steht über das Ende des zweiten Bauelements 80 hinaus.

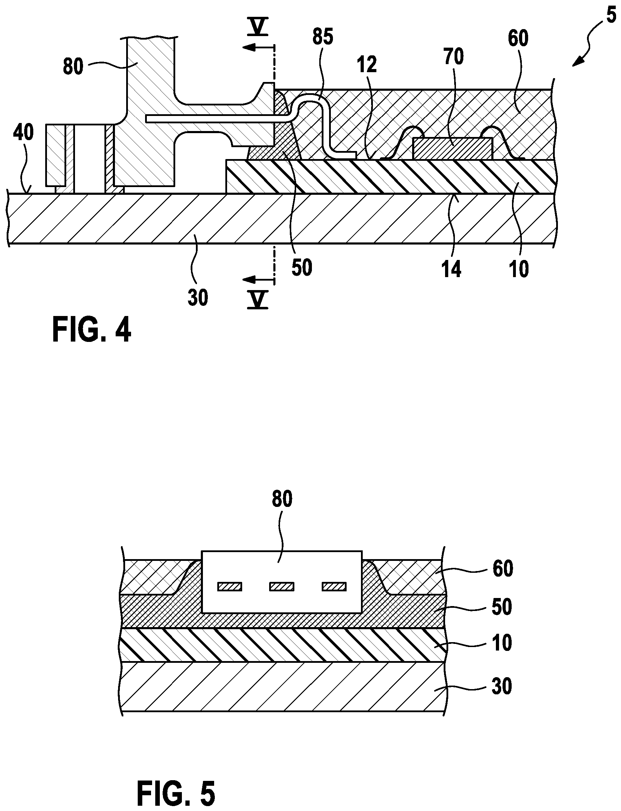

Fig. 4 zeigt eine schematische Ansicht einer elektronischen Baugruppe 5. Fig. 4 zeigt somit eine schematische Ansicht nach einem vierten bzw. fünften Schritt des erfindungsgemäßen Verfahrens zum Herstellen einer elektronischen Baugruppe 5.

Ein Abdeckungsmaterial wurde im vierten Schritt auf den Teilbereich 20 der ersten Seite 12 der Leiterplatte 10 (und teilweise auf das Abdichtungsmaterial w50), der von dem Abdichtungsmaterial 50 umgeben ist.

Anschließend werden das Abdichtungsmaterial 50 und das Abdeckungsmaterial ausgehärtet. Dies kann in einem Schritt oder in zwei Schritten ausgeführt werden. Das Aushärten kann z.B. durch Erwärmen des Abdichtungsmaterials 50 und/oder des Abdeckungsmaterials erreicht werden.

Das Abdeckungsmaterial kann ein Epoxidharz sein bzw. umfassen.

Das Abdichtungsmaterial 50 und/oder das Abdeckungsmaterial sind elektrisch isolierend bzw. nicht-leitend.

Die Referenzoberfläche 40 verläuft im Wesentlichen parallel zur ersten Seite 12 der Leiterplatte 10 und der zweiten Seite 14 der Leiterplatte 10.

Das zweite Bauelement 80 kann die Referenzoberfläche 40 flächig berühren, d.h. nicht nur punktuell.

Fig. 5 zeigt eine Querschnittsansicht der elektronischen Baugruppe 5 aus Fig. 4 entlang der Linie V-V. In Fig. 5 ist zu sehen, dass das zweite Bauelement 80 in das Abdichtungsmaterial 50 eingedrückt ist. Die obere Kante des Abdichtungsmaterials 50 kann mit der Oberkante des zweiten Bauelements 80 bündig abschließen.

Vorstellbar ist auch, dass die obere Kante des zweiten Bauelements 80 über die Kante des Abdichtungsmaterials 50 (nach oben) hinaussteht.

Die Figuren zeigen jeweils nur einen Ausschnitt. Die Leiterplatte erstreckt sich in den Fig. 1-3 weiter nach rechts. In Fig. 4 erstrecken sich die Leiterplatte 10 und das Bedeckungsmaterial 60 weiter nach rechts. Weiter rechts von dem in Fig. 4 gezeigten Ausschnitt können weitere elektrische Bauelemente auf der ersten Seite 12 der Leiterplatte 10 angeordnet sein.

In Fig. 5 erstreckt sich die Leiterplatte 10, das Abdichtungsmaterial 50 und das Bedeckungsmaterial 60 weiter nach rechts und weiter nach links.

Abschließend ist darauf hinzuweisen, dass Begriffe wie "aufweisend", "umfassend", etc. keine anderen Elemente oder Schritte ausschließen und Begriffe wie "eine" oder "ein" keine Vielzahl ausschließen. Bezugszeichen in den Ansprüchen sind nicht als Einschränkung anzusehen.

## Patentansprüche

1. Verfahren zum Herstellen einer elektronischen Baugruppe (5), insbesondere für ein Getriebesteuermodul, folgende Schritte umfassend:
Bereitstellen einer Leiterplatte (10) mit einer ersten Seite (12) und einer von der ersten Seite (12) abgewandten zweite Seite (14) und mit wenigstens einem ersten auf der ersten Seite (12) der Leiterplatte (10) angeordneten elektronischen Bauelement (70);
Anordnen der Leiterplatte (10) mit der zweiten Seite (14) zumindest teilweise auf einer Referenzoberfläche (40);
Aufbringen eines vor einem Aushärten nicht-fließfähigen Abdichtungsmaterials (50) mit hoher Viskosität auf die erste Seite (12), wobei das Abdichtungsmaterial (50) nach dem Aufbringen nicht fließt, so dass sich die von dem Abdichtungsmaterial (50) bedeckte Fläche nach dem Aufbringen auf die erste Seite (12) der Leiterplatte (10) und vor dem Eindrücken eines zweiten Bauelementes (80) nicht ändert, und wobei das Abdichtungsmaterial (50) derart aufgebracht wird, dass das Abdichtungsmaterial (50) einen Teilbereich (20) der ersten Seite (12) der Leiterplatte (10) umgibt;
Anordnen eines zweiten Bauelements (80) zumindest teilweise auf der Referenzoberfläche (40) derart, dass das zweite Bauelement (80) teilweise in das Abdichtungsmaterial (50) eingedrückt wird; wobei der Schritt des Anordnens des zweiten Bauelementes (80) nach dem Schritt der Aufbringung des nicht-fließfähigen Abdichtungsmaterials (50) erfolgt;
Elektrisches Verbinden des zweiten Bauelements (80) mit der Leiterplatte (10) mittels einer elektrischen Verbindungsleitung (85);
Aufbringen eines Bedeckungsmaterials (60), insbesondere eines vor einem Aushärten fließfähigen Bedeckungsmaterials (60), auf den von dem Abdichtungsmaterial (50) umgebenen Teilbereich (20) der ersten Seite (12) der Leiterplatte (10) und auf das erste Bauelement (70);
Aushärten des Abdichtungsmaterials (50); und
Aushärten des Bedeckungsmaterials (60).

2. Verfahren nach Anspruch 1, wobei
die Referenzoberfläche (40) die Oberfläche einer Wärmesenke (30) zum Ableiten von Wärme aus der elektronischen Baugruppe (5) ist.

3. Verfahren nach Anspruch 1 oder 2, wobei
die Referenzoberfläche (40) die Oberfläche eines Montagehilfsmittels ist, und wobei das Verfahren ferner folgenden Schritt umfasst:
Entfernen der Leiterplatte (10) und des zweiten Bauelements (80) von dem Montagehilfsmittel.

4. Verfahren nach Anspruch einem der vorhergehenden Ansprüche, wobei das Abdichtungsmaterial (50) auf einen Randbereich der ersten Seite (12) der Leiterplatte (10) aufgebracht wird.

5. Verfahren nach einem der vorhergehenden Ansprüche, wobei das Bedeckungsmaterial (60) derart auf die erste Seite (12) der Leiterplatte (10) aufgebracht wird, dass das Bedeckungsmaterial (60) die elektrische Verbindungsleitung (85) bedeckt und/oder umschließt.

6. Verfahren nach einem der vorhergehenden Ansprüche, wobei das Abdichtungsmaterial (50) und das Bedeckungsmaterial (60) einen gleichen Wärmeausdehnungskoeffizienten aufweisen.

## Claims

1. Method for producing an electronic assembly (5), in particular for a transmission control module, comprising the following steps:
providing a printed circuit board (10) having a first side (12) and a second side (14), facing away from the first side (12), and having at least one first electronic component (70) arranged on the first side (12) of the printed circuit board (10);
arranging the printed circuit board (10) with the second side (14) at least partially on a reference surface (40);
applying a sealing material (50) of high viscosity that is not flowable prior to being cured to the first side (12),
wherein the sealing material (50) does not flow after being applied, so that the area covered by the sealing material (50) does not change after application to the first side (12) of the printed circuit board (10) and before the pressing in of a second component (80), and wherein the sealing material (50) is applied in such a way that the sealing material (50) surrounds a sub-region (20) of the first side (12) of the printed circuit board (10);
arranging a second component (80) at least partially on the reference surface (40) in such a way that the second component (80) is partially pressed into the sealing material (50); wherein the step of arranging the second component (80) is performed after the step of applying the non-flowable sealing material (50);
electrically connecting the second component (80) to the printed circuit board (10) by means of an electrical connecting line (85);
applying a covering material (60), in particular a covering material (60) that is flowable prior to being cured, to the sub-region (20) of the first side (12) of the printed circuit board (10) that is surrounded by the sealing material (50) and to the first component (70);
curing the sealing material (50); and
curing the covering material (60).

2. Method according to Claim 1, wherein
the reference surface (40) is the surface of a heat sink (30) for dissipating heat from the electronic assembly (5).

3. Method according to Claim 1 or 2, wherein
the reference surface (40) is the surface of a mounting aid, and wherein the method also comprises the following step:
removing the printed circuit board (10) and the second component (80) from the mounting aid.

4. Method according to claim one of the preceding claims, wherein
the sealing material (50) is applied to a peripheral region of the first side (12) of the printed circuit board (10).

5. Method according to one of the preceding claims,
wherein
the covering material (60) is applied to the first side (12) of the printed circuit board (10) in such a way that the covering material (60) covers and/or encloses the electrical connecting line (85).

6. Method according to one of the preceding claims, wherein
the sealing material (50) and the covering material (60) have the same coefficient of thermal expansion.

## Revendications

1. Procédé de fabrication d'un ensemble électronique (5), en particulier pour un module de commande de boîte de vitesses, comprenant les étapes suivantes consistant à :
prévoir une carte de circuits imprimés (10) dotée d'une première face (12) et d'une deuxième face (14) détournée de la première face (12) et dotée d'au moins un premier composant électronique (70) disposé sur la première face (12) de la carte de circuits imprimés (10) ;
disposer la carte de circuits imprimés (10) avec la deuxième face (14) au moins en partie sur une surface de référence (40) ;
appliquer sur la première face (12) un matériau d'étanchéité (50) à viscosité élevée, non coulant avant durcissement, le matériau d'étanchéité (50) ne coulant pas après application de sorte que la surface recouverte par le matériau d'étanchéité (50) ne change pas après l'application sur la première face (12) de la carte de circuits imprimés (10) et avant l'insertion d'un deuxième composant (80), et le matériau d'étanchéité (50) étant appliqué de telle sorte que le matériau d'étanchéité (50) entoure une zone partielle (20) de la première face (12) de la carte de circuits imprimés (10) ;
disposer un deuxième composant (80) au moins en partie sur la surface de référence (40) de telle sorte que le deuxième composant (80) est inséré en partie dans le matériau d'étanchéité (50) ; l'étape consistant à disposer le deuxième composant (80) étant effectuée après l'étape consistant à appliquer le matériau d'étanchéité non coulant (50) ;
connecter électriquement le deuxième composant (80) à la carte de circuits imprimés (10) au moyen d'une ligne de connexion électrique (85) ;
appliquer un matériau de recouvrement (60), en particulier un matériau de recouvrement (60) coulant avant durcissement, sur la zone partielle (20), entourée du matériau d'étanchéité (50), de la première face (12) de la carte de circuits imprimés (10) et sur le premier composant (70) ;
laisser durcir le matériau d'étanchéité (50) ; et
laisser durcir le matériau de recouvrement (60).

2. Procédé selon la revendication 1, dans lequel la surface de référence (40) est la surface d'un dissipateur thermique (30) pour dissiper la chaleur de l'ensemble électronique (5).

3. Procédé selon la revendication 1 ou 2, dans lequel la surface de référence (40) est la surface d'un moyen d'aide au montage, et dans lequel le procédé comprend en outre l'étape suivante consistant à :
retirer la carte de circuits imprimés (10) et le deuxième composant (80) du moyen d'aide au montage.

4. Procédé selon la revendication l'une quelconque des revendications précédentes, dans lequel le matériau d'étanchéité (50) est appliqué sur une zone marginale de la première face (12) de la carte de circuits imprimés (10).

5. Procédé selon l'une quelconque des revendications précédentes, dans lequel le matériau de recouvrement (60) est appliqué sur la première face (12) de la carte de circuits imprimés (10) de telle sorte que le matériau de recouvrement (60) recouvre et/ou entoure la ligne de connexion électrique (85).

6. Procédé selon l'une quelconque des revendications précédentes, dans lequel le matériau d'étanchéité (50) et le matériau de recouvrement (60) présentent le même coefficient de dilatation thermique.
